(19) Europäisches Patentamt
European Patent Office
Office européen des brevets

(11) **EP 3 948 359 B1**

(12) **EUROPEAN PATENT SPECIFICATION**

(45) Date of publication and mention
of the grant of the patent:
**27.12.2023 Bulletin 2023/52**

(21) Application number: **19922720.8**

(22) Date of filing: **29.03.2019**

(51) International Patent Classification (IPC):
**G01T 3/08** (2006.01)

(52) Cooperative Patent Classification (CPC):
**G01T 1/24; H01L 27/14658; H01L 27/14683**

(86) International application number:
**PCT/CN2019/080402**

(87) International publication number:
**WO 2020/198929 (08.10.2020 Gazette 2020/41)**

(54) **APPARATUSES FOR DETECTING RADIATION AND THEIR METHODS OF MAKING**

VORRICHTUNGEN ZUR STRAHLUNGSDETEKTION UND DEREN HERSTELLUNGSVERFAHREN

APPAREILS DE DÉTECTION DE RAYONNEMENT ET LEURS PROCÉDÉS DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.02.2022 Bulletin 2022/06**

(73) Proprietor: **Shenzhen Xpectvision Technology
Co., Ltd.
Shenzhen, Guangdong 518000 (CN)**

(72) Inventors:
• **LIU, Yurun
Shenzhen, Guangdong 518000 (CN)**
• **CAO, Peiyan
Shenzhen, Guangdong 518000 (CN)**

(74) Representative: **Beck Greener LLP
Fulwood House
12 Fulwood Place
London WC1V 6HR (GB)**

(56) References cited:
**WO-A1-2018/201308       WO-A1-2019/019040
JP-A- 2011 257 255       KR-A- 20140 083 747
US-A1- 2006 138 477**

## Description

## Technical Field

The disclosure herein relates to apparatuses for detecting radiation and methods of making them.

## Background

A radiation detector is a device that measures a property of a radiation. Examples of the property may include a spatial distribution of the intensity, phase, and polarization of the radiation. The radiation may be one that has interacted with a subject. For example, the radiation measured by the radiation detector may be a radiation that has penetrated or reflected from the subject. The radiation may be an electromagnetic radiation such as infrared light, visible light, ultraviolet light, X-ray or $\gamma$-ray. The radiation may be of other types such as $\alpha$-rays and $\beta$-rays.

One type of radiation detectors is based on interaction between the radiation and a semiconductor. For example, a radiation detector of this type may have a semiconductor layer that absorbs the radiation and generate charge carriers (e.g., electrons and holes) and circuitry for detecting the charge carriers.

Cadmium Zinc Telluride (CdZnTe, or $Cd_{1-x}Zn_xTe$) is a direct gap semiconductor and is an excellent candidate for room temperature radiation detection. Cadmium Zinc Telluride is an alloy of zinc telluride and cadmium telluride (CdTe) and the x-value is the molar concentration of Zn in CdZnTe. CdZnTe with x-value from 0.04 to 0.2 is considered promising for detector development as it processes and improves some of the properties of CdTe. For example, both CdTe and CdZnTe have large atomic number that gives the material excellent stopping power for high absorption efficiencies for incident X-rays, $\gamma$-rays, and have large band gaps (e.g., 1.5 eV- 1.6 eV) allowing room temperature detector operations and have high resistivity to achieve a good signal-to-noise ratio of the radiation detectors. Meanwhile, the CdZnTe has a larger band gap than CdTe due to incorporation of Zn hence increases the maximum achievable electrical resistivity.

The practical use of CdTe and CdZnTe detectors covers a wide variety of applications, such as medical and industrial imaging, industrial gauging and non-destructive testing, security and monitoring, nuclear safeguards and non-proliferation, and astrophysics. US2006/138477 discloses an asymmetric recessed gate MOSFET, and a method for manufacturing the same. The asymmetric recessed gate MOSFET comprises: recess regions formed at a predetermined depth in a semiconductor; recessed gate electrodes formed at a predetermined height on a semiconductor substrate by gapfilling the recess regions, and misaligned with the recess region corresponding to one of the source/drain regions; spacers formed on sides of the recessed gate electrodes; and source/drain regions implanted with a dopant formed in the semiconductor substrate exposed between the spacers. KR20140083747 discloses a manufacturing method for a semiconductor device to increase a contact area between a contact plug and an active region. The manufacturing method comprises a step of forming an element isolation layer which defines an active region on a substrate; a step of forming a trench in the active region and the element isolation layer; a step of forming a gate electrode recessed in the trench; a step of forming a sealing pattern on the gate electrode; a step of forming a recess by etching the active region to be self-aligned on the sealing pattern and the element isolation layer; a step of growing a silicon containing layer filling a gap; a step of forming a pad by converting the silicon containing layer into metal silicide; and a step of forming a contact plug on the pad. JP2011257255 discloses a cylindrical recess provided at the centre portion of a bottom surface of a cylindrical p-type semiconductor tablet. An n-layer and an n-surface electrode are provided at the centre portion of a bottom surface of the recess. WO2019/019040 discloses a system comprising a first X-ray source having a plurality of X-ray generators configured to respectively emit a plurality of X-rays toward an object; and a first X-ray detector configured to detect images of the object formed respectively by the plurality of X-rays from the first X-ray source.

## Summary

According to a first aspect of the present invention, there is provided a method comprising: forming a recess into a semiconductor substrate, wherein a portion of the semiconductor substrate extends into the recess and is surrounded by the recess; forming a semiconductor single crystal in the recess, the semiconductor single crystal having a different composition from the semiconductor substrate; forming a first doped semiconductor region in the semiconductor substrate; forming a second doped semiconductor region in the semiconductor substrate; wherein the first doped semiconductor region and the second doped semiconductor region form a p-n junction that separates the portion from the rest of the semiconductor substrate.

According to an embodiment, the first doped semiconductor region surrounds the second doped semiconductor region.

According to an embodiment, the second doped semiconductor region is in electrical contact with the portion.

According to an embodiment, forming the second doped semiconductor region comprises doping a portion of the first doped semiconductor region.

According to an embodiment, the first doped semiconductor region extends from a surface of the semiconductor substrate to an interface between the semiconductor single crystal and the semiconductor substrate.

According to an embodiment, the second doped semiconductor region is coextensive with the first doped semiconductor region.

According to an embodiment, forming the recess comprises forming a mask on the semiconductor substrate and etching an area of the semiconductor substrate uncovered by the mask.

According to an embodiment, the mask comprises a metal, silicon nitride, silicon dioxide, or carbon.

According to an embodiment, etching the area is by wet etching, dry etching or a combination thereof.

According to an embodiment, the method disclosed herein further comprises polishing the semiconductor substrate or the semiconductor single crystal so that the semiconductor single crystal and the semiconductor substrate are coextensive.

According to an embodiment, the semiconductor substrate comprises silicon, germanium, GaAs or a combination thereof.

According to an embodiment, the semiconductor single crystal is a cadmium zinc telluride (CdZnTe) single crystal or a cadmium telluride (CdTe) single crystal.

According to an embodiment, the recess does not contain other semiconductor material except the semiconductor single crystal, after forming the semiconductor single crystal.

According to an embodiment, the recess does not contain a semiconductor polycrystal, after forming the semiconductor single crystal.

According to an embodiment, the recess has a shape of a frustum, prism, pyramid, cuboid, or cylinder.

According to an embodiment, forming the semiconductor single crystal in the recess comprises depositing semiconductor particles into the recess, forming a melt by melting the semiconductor particles, and recrystallizing the melt in the recess.

According to an embodiment, recrystallizing the melt in the recess involves cooling the melt at a rate that the melt recrystallizes into a single crystal.

According to an embodiment, cooling the melt is done by moving the melt from a zone with a temperature above or equal to a melting point of the semiconductor particles to another zone with a temperature below the melting point.

According to an embodiment, forming the semiconductor single crystal comprises using a vapor phase precursor.

According to an embodiment, the method disclosed herein further comprises bonding the semiconductor substrate to another substrate comprising an electronic system therein or thereon, wherein the electronic system is electrically connected to the second doped semiconductor region and configured to process an electrical signal generated in the semiconductor substrate.

According to a second aspect of the present invention, there is provided a method comprising: forming a through hole in a semiconductor layer supported directly on an electrical insulator layer, wherein a portion of the semiconductor layer remains in and is surrounded by the through hole; forming a semiconductor single crystal in the through hole, the semiconductor single crystal having a different composition from the semiconductor layer; forming an opening through the electrical insulator layer so that the portion is exposed in the opening; forming an electrode in the opening, the electrode being in electrical contact to the portion.

According to an embodiment, forming the through hole comprises forming a mask on the semiconductor layer and etching an area of the semiconductor layer uncovered by the mask.

According to an embodiment, the mask comprises a metal, silicon nitride, silicon dioxide, or carbon.

According to an embodiment, etching the area is by wet etching, dry etching or a combination thereof.

According to an embodiment, the method disclosed herein further comprises polishing the semiconductor layer or the semiconductor single crystal so that the semiconductor single crystal and the semiconductor layer are coextensive.

According to an embodiment, the semiconductor layer comprises silicon, germanium, GaAs or a combination thereof.

According to an embodiment, the electrical insulator layer comprises an oxide, a nitride or an oxynitride.

According to an embodiment, the semiconductor single crystal is a cadmium zinc telluride (CdZnTe) single crystal or a cadmium telluride (CdTe) single crystal.

According to an embodiment, the through hole does not contain other semiconductor material except the semiconductor single crystal, after forming the semiconductor single crystal.

According to an embodiment, the through hole does not contain a semiconductor polycrystal, after forming the semiconductor single crystal.

According to an embodiment, the through hole has a shape of a frustum, prism, pyramid, cuboid, or cylinder.

According to an embodiment, forming the semiconductor single crystal in the through hole comprises depositing semiconductor particles into the through hole, forming a melt by melting the semiconductor particles, and recrystallizing the melt in the through hole.

According to an embodiment, recrystallizing the melt in the through hole involves cooling the melt at a rate that the melt recrystallizes into a single crystal.

According to an embodiment, cooling the melt is done by moving the melt from a zone with a temperature above or equal to a melting point of the semiconductor particles to another zone with a temperature below the melting point.

According to an embodiment, forming the semiconductor single crystal comprises using a vapor phase precursor.

According to an embodiment, the method disclosed herein further comprises bonding the electrical insulator layer to an electronics layer comprising an electronic system electrically connected to the electrode and configured to process an electrical signal generated in the semiconductor layer.

Disclosed herein is a radiation detector comprising: a semiconductor substrate; a recess in the semiconductor substrate, wherein a portion of the semiconductor substrate extends into the recess and is surrounded by the recess; a semiconductor single crystal in the recess, the semiconductor single crystal having a different composition from the semiconductor substrate; a first doped semiconductor region in the semiconductor substrate; a second doped semiconductor region in the semiconductor substrate; wherein the first doped semiconductor region and the second doped semiconductor region form a p-n junction that separates the portion from the rest of the semiconductor substrate.

According to an embodiment, the radiation detector is configured to absorb particles of radiation incident on the semiconductor single crystal and to generate charge carriers.

According to an embodiment, the first doped semiconductor region surrounds the second doped semiconductor region.

According to an embodiment, the second doped semiconductor region is in electrical contact with the portion.

According to an embodiment, the first doped semiconductor region extends from a surface of the semiconductor substrate to an interface between the semiconductor single crystal and the semiconductor substrate.

According to an embodiment, the second doped semiconductor region is coextensive with the first doped semiconductor region.

According to an embodiment, the semiconductor single crystal and the semiconductor substrate are coextensive.

According to an embodiment, the semiconductor substrate comprises silicon, germanium, GaAs or a combination thereof.

According to an embodiment, the semiconductor single crystal is a CdZnTe single crystal or a CdTe single crystal.

According to an embodiment, the recess does not contain other semiconductor material except the semiconductor single crystal.

According to an embodiment, the recess does not contain a semiconductor polycrystal.

According to an embodiment, the recess has a shape of a frustum, prism, pyramid, cuboid, or cylinder.

According to an embodiment, the detector disclosed herein further comprises an electronics layer bonded to the semiconductor substrate, the electronics layer comprising an electronic system electrically connected to the second doped semiconductor region and configured to process an electrical signal generated in the semiconductor substrate.

Disclosed herein is a radiation detector comprising: an electrical insulator layer; a semiconductor layer supported directly on the electrical insulator layer; a through hole in the semiconductor layer, wherein a portion of the semiconductor layer extends into the through hole and is surrounded by the through hole; a semiconductor single crystal in the through hole, the semiconductor single crystal having a different composition from the semiconductor layer; an electrode through the electrical insulator layer, the electrode being in electrical contact to the portion.

According to an embodiment, the semiconductor layer comprises silicon, germanium, GaAs or a combination thereof.

According to an embodiment, the electrical insulator layer comprises an oxide, a nitride or an oxynitride.

According to an embodiment, the semiconductor single crystal is a cadmium zinc telluride (CdZnTe) single crystal or a cadmium telluride (CdTe) single crystal.

According to an embodiment, the through hole does not contain other semiconductor material except the semiconductor single crystal, after forming the semiconductor single crystal.

According to an embodiment, the through hole does not contain a semiconductor polycrystal, after forming the semiconductor single crystal.

According to an embodiment, the through hole has a shape of a frustum, prism, pyramid, cuboid, or cylinder.

According to an embodiment, the radiation detector disclosed herein further comprises an electronics layer bonded to the electrical insulator layer, the electronics layer comprising an electronic system electrically connected to the electrode and configured to process an electrical signal generated in the semiconductor layer.

The invention relates to methods of manufacturing a semiconductor radiation detector according to claims 1 and 10, and a radiation detector according to claim 15 manufactured in accordance with one of the claimed methods.

**Brief Description of Figures**

Fig. 1 schematically shows a cross-sectional view of a radiation detector, according to an embodiment.
Fig. 2A schematically shows a detailed cross-sectional view of the radiation detector, according to an embodiment.
Fig. 2B schematically shows a detailed cross-sectional view of the radiation detector, according to an embodiment.
Fig. 2C-Fig. 2E each schematically show a top view of the radiation absorption layer, according to an embodiment.

Fig. 3 schematically illustrates a process of forming the radiation absorption layer in Fig. 2A, according to an embodiment.

Fig. 4 schematically illustrates a process of forming recess of the radiation absorption layer in Fig. 2A, according to an embodiment.

Fig. 5 schematically illustrates a process of forming a semiconductor single crystal in the recess of the radiation absorption layer in Fig. 2A, according to an embodiment.

Fig. 6 schematically illustrates a process of forming the radiation absorption layer in Fig. 2B, according to an embodiment.

Fig. 7 schematically illustrates a process of forming through hole of the radiation absorption layer in Fig. 2B, according to an embodiment.

Fig. 8 schematically illustrates a process of forming a semiconductor single crystal in the through hole of the radiation absorption layer in Fig. 2A, according to an embodiment.

Fig. 9A and Fig. 9B each schematically illustrates bonding between the radiation absorption layer and the electronics layer to form the radiation detector as shown respectively in Fig. 2A and Fig. 2B, according an embodiment.

Fig. 10A and Fig. 10B each show a component diagram of the electronic system, according to an embodiment.

Fig. 11 schematically shows a temporal change of the voltage of the electrode or the electrical contact, according to an embodiment.

**Detailed Description**

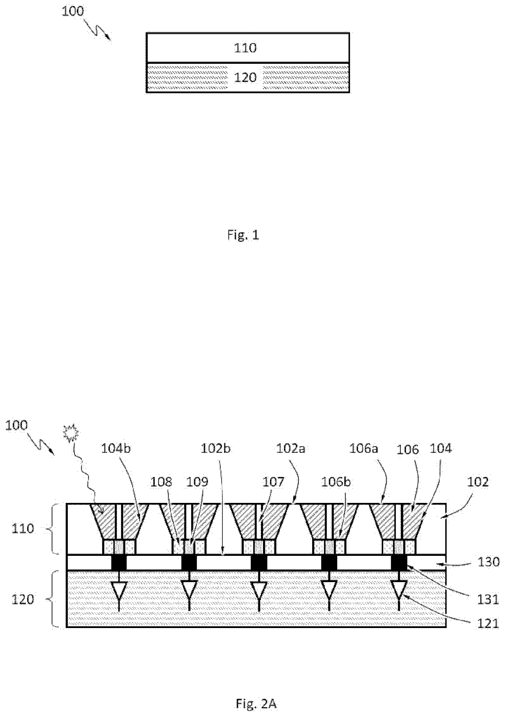

Fig. 1 schematically shows a cross-sectional view of a radiation detector 100, according to an embodiment. The radiation detector 100 may include a radiation absorption layer 110 configured to absorb incident radiation and generate electrical signals from the incident radiation, and an electronics layer 120 (e.g., an ASIC) for processing or analyzing the electrical signals generated in the radiation absorption layer 110. The radiation detector 100 may or may not include a scintillator. The radiation absorption layer 110 may include a semiconductor material such as, silicon, germanium, GaAs, CdTe, CdZnTe, or a combination thereof. The semiconductor may have a high mass attenuation coefficient for the radiation of interest.

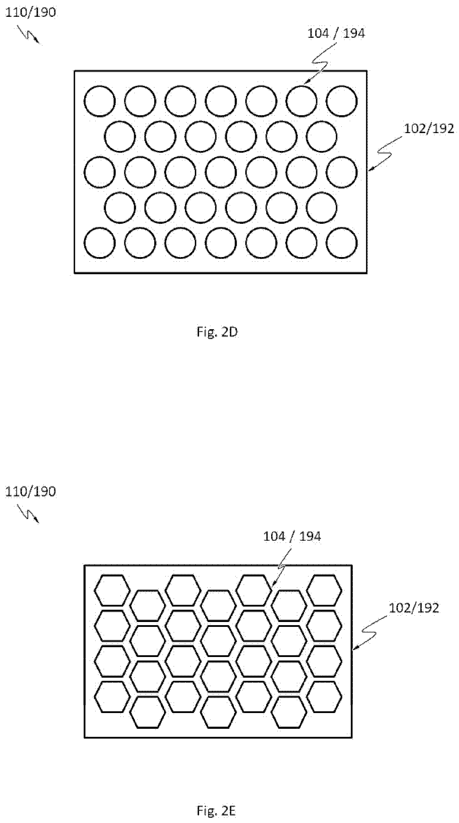

Fig. 2A schematically shows a detailed cross-sectional view of the radiation detector 100, according to an embodiment. The radiation detector 100 has a semiconductor substrate 102 and a recess 104 in the semiconductor substrate 102. A portion 107 of the semiconductor substrate 102 extends into the recess 104 and is surrounded by the recess 104. The radiation detector 100 has a semiconductor single crystal 106 in the recess 104. The radiation detector 100 further has a first doped semiconductor region 108 in the semiconductor substrate 102 and a second doped semiconductor region 109 in the semiconductor substrate 102. The first doped semiconductor region 108 and the second doped semiconductor region 109 form a p-n junction that separates the portion 107 from the rest of the semiconductor substrate 102. In other words, every electric pathway between the portion 107 and the rest of the semiconductor substrate 102 and entirely inside the semiconductor substrate 102 traverses this p-n junction. The portion 107 may be in electrical contact with the second doped semiconductor region 109. The semiconductor substrate 102 (including the portion 107), the semiconductor single crystal 106, the first doped semiconductor region 108, and the second doped semiconductor region 109 may be in the radiation absorption layer 110.

The semiconductor substrate 102 may have a semiconductor material such as silicon, germanium, GaAs, a combination thereof, or other suitable semiconductors. The semiconductor substrate 102 may be an extrinsic semiconductor (i.e., doped with electron donors or electron acceptors).

The second doped semiconductor region 109 may be surrounded by the first doped semiconductor region 108. The second doped semiconductor region 109 is not necessarily in the center of the first doped semiconductor region 108. The first doped semiconductor region 108 may extend from a surface 102b of the semiconductor substrate 102 to an interface 106b between the semiconductor single crystal 106 and the semiconductor substrate 102. The second doped semiconductor region 109 may be coextensive with the first doped semiconductor region 108, for example, in a direction perpendicular to the semiconductor substrate 102.

The portion 107 may be a cylinder or prism (e.g., rectangular prism or triangular prism). The portion 107 may have a height (i.e., a dimension in a direction perpendicular to the semiconductor substrate 102) equal to, longer than or shorter than the height of the recess 104. The portion 107 may have a height of a few micrometers. The portion 107 may have the same type of doping as the second doped semiconductor region 109 (e.g., both n-type or both p-type), but have the opposite type of doping from the rest of the semiconductor substrate 102 (e.g., the portion 107 being n-type and the rest of the semiconductor substrate 102 being p-type, or vice versa).

In an embodiment, the recess 104 has one and only one semiconductor single crystal 106. For example, the recess 104 contains no other semiconductor material except the one semiconductor single crystal 106. For example, the recess 104 does not contain a semiconductor polycrystal. The semiconductor single crystal 106 may be coextensive with the semiconductor substrate 102 (i.e., surface 106a of the semiconductor single crystal 106 may be coextensive with the surface 102a of the semiconductor substrate 102). The semiconductor single crystal 106 has a different composition from the semiconductor substrate 102. Namely, the semiconductor single crystal 106 does not merely differ from the semiconductor substrate 102 in terms of doping. The semiconductor single crystal 106 is not formed by doping the semiconductor substrate 102. For example, if the semiconductor substrate 102 is doped silicon, the semiconductor single crystal 106 is not doped silicon or intrinsic silicon. The semiconductor single crystals 106 may be a cadmium zinc telluride (CdZnTe) single crystal, a cadmium telluride (CdTe) single crystal, or another suitable single crystal that can absorb particles of radiation incident thereon and generate charge carriers. The semiconductor single crystal 106 may have a sufficient thickness and thus a sufficient absorbance (e.g., >80% or >90%) for incident particles of radiation of interest (e.g., X-ray photons). The semiconductor single crystal 106 is in electrical contact with the portion 107 and the rest of the semiconductor substrate 102.

When the radiation hits the radiation absorption layer 110, the semiconductor single crystals 106 may absorb the particles of radiation incident thereon and generate one or more charge carriers by a number of mechanisms. A particle of radiation may generate 1 to 100000 charge carriers. The charge carriers may comprise electrons and holes. The charge carriers may drift to a sidewall 104b of the recess 104 and the portion 107 under an electric field between the portion 107 and the rest of the semiconductor substrate 102. For example, the holes may drift to the sidewall 104b, and the electrons may drift to the portion 107.

In an embodiment, the p-n junction formed by the first doped semiconductor region 108 and the second doped semiconductor region 109 may be under a reverse bias during operation of the radiation detector 100. This reverse bias may be used to establish the electric field between the portion 107 and the rest of the semiconductor substrate 102. The p-n junction under the reverse bias essentially blocks electric current traversing the p-n junction but allows electric current to flow between the portion 107 and the electronics layer 120 through the second doped semiconductor region 109.

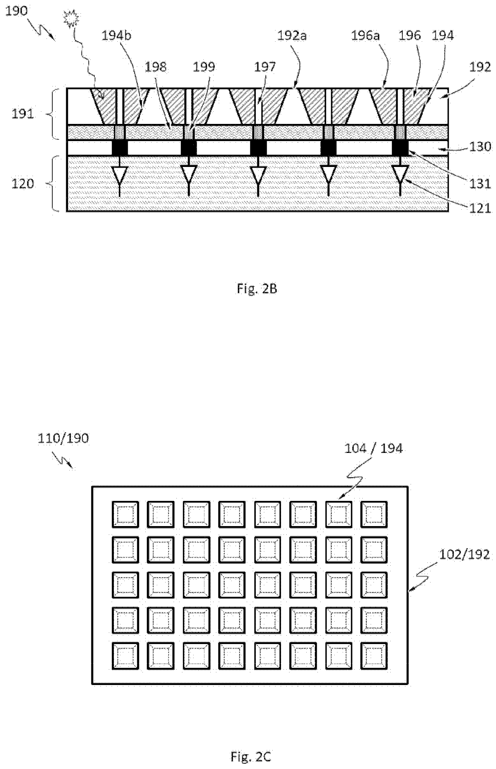

Fig. 2B schematically shows a detailed cross-sectional view of the radiation detector 190, according to an embodiment. The radiation detector 190 has an electrical insulator layer 198, a semiconductor layer 192 supported directly on the electrical insulator layer 198, and a through hole 194 in the semiconductor layer 192. A portion 197 of the semiconductor layer 192 extends into the through hole 194 and is surrounded by the through hole 194. The radiation detector 190 has a semiconductor single crystal 196 in the through hole 194. The radiation detector 190 also has an electrode 199 in (e.g., through) the electrical insulator layer 198 and in electrical contact with the portion 197. The semiconductor layer 192 (including the portion 197), the semiconductor single crystal 196, the electrical insulator layer 198, and the electrode 199 may be in a radiation absorption layer 191.

The semiconductor layer 192 may have a semiconductor material such as silicon, germanium, GaAs, or a combination thereof. The semiconductor layer 192 may be an extrinsic semiconductor (i.e., doped with electron donors or electron acceptors).

The electrical insulator layer 198 may be an oxide, a nitride or an oxynitride or other suitable materials.

The portion 197 may be a cylinder or prism (e.g., rectangular prism or triangular prism). The portion 197 may have a height (i.e., a dimension in a direction perpendicular to the semiconductor layer 192) equal to, longer than or shorter than the height of the through hole 194. The portion 197 may have a height of a few micrometers.

In an embodiment, the through hole 194 has one and only one semiconductor single crystal 196. For example, the through hole 194 contains no other semiconductor material except the one semiconductor single crystal 196. For example, the through hole 194 does not contain a semiconductor polycrystal. The semiconductor single crystal 196 may be coextensive with the semiconductor layer 192 (i.e., surface 196a of the semiconductor single crystal 196 may be coextensive with the surface 192a of the semiconductor layer 192). The semiconductor single crystal 196 has a different composition from the semiconductor layer 192. Namely, the semiconductor single crystal 196 does not merely differ from the semiconductor layer 192 in terms of doping. The semiconductor single crystal 196 is not formed by doping the semiconductor layer 192. For example, if the semiconductor layer 192 is doped silicon, the semiconductor single crystal 196 is not doped silicon or intrinsic silicon. The semiconductor single crystals 196 may be a cadmium zinc telluride (CdZnTe) single crystal, a cadmium telluride (CdTe) single crystal, or another suitable single crystal that can absorb particles of radiation incident thereon and generate charge carriers. The semiconductor single crystal 196 may have a sufficient thickness and thus a sufficient absorbance (e.g., >80% or >90%) for incident particles of radiation of interest (e.g., X-ray photons). The semiconductor single crystal 196 is in electrical contact with the portion 197 and the rest of the semiconductor layer 192.

The electrode 199 may comprise an electrically conducting material such as a metal (e.g., gold, copper, aluminum, platinum, etc.), or any other suitable conducting materials (e.g., a doped semiconductor). The electrode 199 may be embedded in the electrical insulator layer 198 or may extend through the entire thickness of the electrical insulator layer 198.

When the radiation hits the radiation absorption layer 191, the semiconductor single crystals 196 may absorb the particles of radiation incident thereon and generate one or more charge carriers by a number of mechanisms. A particle of the radiation may generate 1 to 100000 charge carriers. The charge carriers may comprise electrons and holes. The charge carriers may drift to a sidewall 194b of the through hole 194 and the portion 197 under an electric field between the portion 197 and the rest of the semiconductor layer 192. For example, the holes may drift to the sidewall 194b, and the electrons may drift to the portion 197.

The recess 104 and the through hole 194 may have a shape of a frustum, prism, pyramid, cuboid, cubic, cylinder or other suitable shapes. The radiation detector 100 or the radiation detector 190 may have multiple copies of recesses 104 or through holes 194 respectively, which may be arranged into an array such as a rectangular array, a honeycomb array, a hexagonal array or any other suitable array. Fig. 2C-Fig. 2E schematically show top views of several examples of the radiation detector 100 or 190 with copies of the recesses 104 or the through holes 194, with various shapes and arrangements. The spacing between the copies (e.g., the shortest distance between the perimeters of neighboring copies) may be less than 10 μm, less than 20 μm, or less than 30 μm. Each of the copies may have a surface area in the range of 1-10000 μm$^2$ or any other suitable size.

The electronics layer 120 may include an electronic system 121 configured to process electrical signals on the portion 107 or the portion 197 generated from the charge carriers collected. The electronic system 121 may include an analog circuitry such as a filter network, amplifiers, integrators, and comparators, or a digital circuitry such as a microprocessor, and memory. The electronic system 121 may include one or more ADCs. The electronic system 121 may be electrically connected to the portion 107 through a via 131 and the second doped semiconductor region 109, or electrically connected to the portion 197 through a via 131 and the electrode 199. Space among the vias may be filled with a filler material 130, which may increase the mechanical stability of the connection of the electronics layer 120 to the radiation absorption layer 110. Other bonding techniques are possible to connect the electronic system 121 to the portion 107 or the portion 197 without using vias.

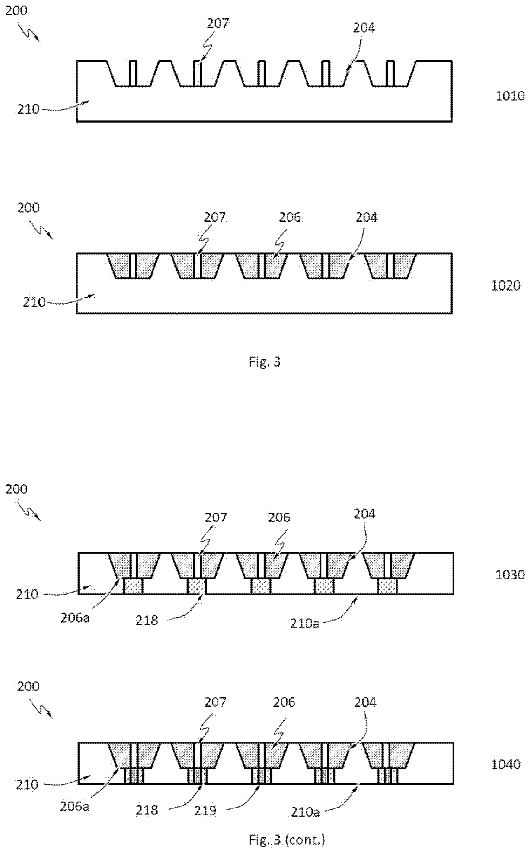

Fig. 3 schematically illustrates a process of forming a radiation absorption layer 200, according to an embodiment.

In step 1010, a recess 204 is formed into a semiconductor substrate 210, according to an embodiment. A portion 207 of the semiconductor substrate 210 extends into the recess 204 and the portion 207 is surrounded by the recess 204. The recesses 204 may function as the recesses 104 in Fig. 2A. The portion 207 may function as the portion 107 in Fig. 2A.

In step 1020, a semiconductor single crystal 206 is formed in the recess 204. The semiconductor single crystals 206 have a different composition from the semiconductor substrate 210. Namely, the semiconductor single crystal 206 does not merely differ from the semiconductor substrate 210 in terms of doping. The semiconductor single crystals 206 may function as the semiconductor single crystals 106 of the radiation absorption layer 110 in Fig. 2A.

In step 1030, a first doped semiconductor region 218 is formed in the semiconductor substrate 210.

In step 1040, a second doped semiconductor region 219 is formed in the semiconductor substrate 210. The first doped semiconductor region 218 and the second doped semiconductor region 219 form a p-n junction that separates the portion 207 from the rest of the semiconductor substrate 210. The first doped semiconductor region 218 may surround the second doped semiconductor region 219. The second doped semiconductor region 219 may be in electrical contact with the portion 207.

The second doped semiconductor region 219 may be formed by doping a portion of the first doped semiconductor region 218. The first doped semiconductor region 218 may be formed by doping with p type or n type dopants in the semiconductor substrate 210. The first doped semiconductor region 218 may extend from a surface 210a of the semiconductor substrate 210 to an interface 206a between the semiconductor single crystal 206 and the semiconductor substrate 210. The second doped semiconductor region 219 may be coextensive with the first doped semiconductor region 218. The second doped semiconductor region 219 may be formed by doping with p type or n type dopants in the semiconductor substrate 210 and the dopants used are opposite from the ones used in forming the first doped semiconductor region 218. For example, if the first doped semiconductor region 218 is formed by doping the semiconductor substrate 210 with p type dopant, the second doped semiconductor region 219 is formed by doping with n type dopant, or vice versa.

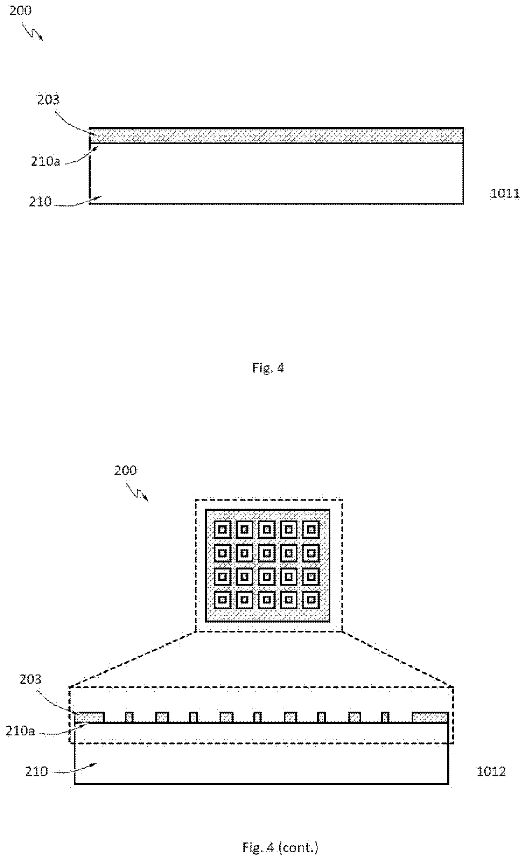

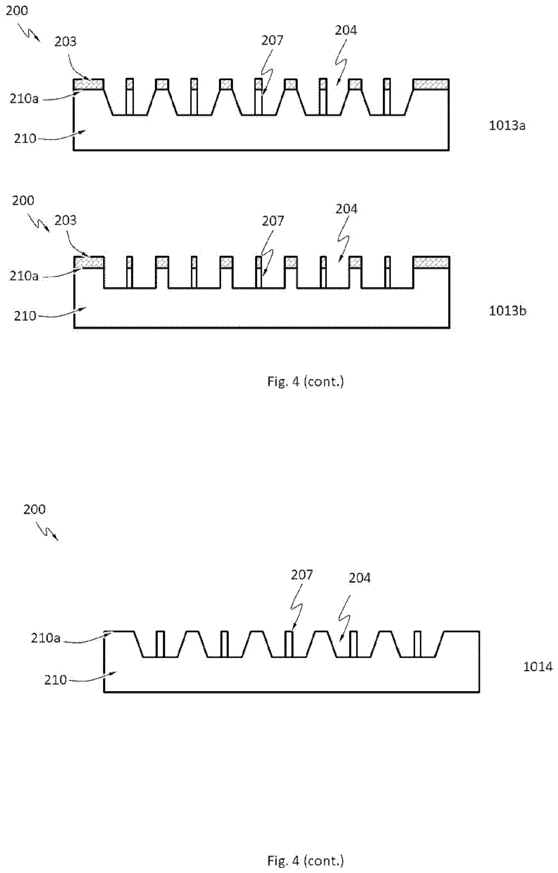

In an embodiment, forming the recess 204 may comprise forming a mask 203 on the semiconductor substrate 210 and etching an area of the semiconductor substrate 210 uncovered by the mask 203, as shown in step 1011 - 1014 of Fig. 4. The mask 203 may be formed onto a surface 210a of the semiconductor substrate 210 and the semiconductor substrate 210 may include a semiconductor material such as, silicon, germanium, GaAs, or a combination thereof. The mask 203 may serve as an etch mask for forming the recess 204 as shown in step 1013a or step 1013b. The mask 203 may comprise a material such as silicon dioxide, silicon nitride, or metals (e.g., aluminum, chromium). The thickness of the mask 203 may be determined according to the depth of the recess 204 and etching selectivity (i.e., ratio of etching rates of the mask 203 and the semiconductor substrate 210). In an embodiment, the mask 203 may have a thickness of a few microns. The mask 203 may be formed onto the surface 210a by various techniques, such as physical vapor deposition, chemical vapor deposition, spin coating, sputtering or any other suitable processes.

In step 1012, the mask 203 is patterned to have openings in which the semiconductor substrate 210 is exposed, shown from a cross-sectional view. Shapes and locations of the openings correspond to the footprint shapes and locations of the recess 204 and other recesses to be formed in step 1013a or step 1013b. If the openings have a square shape (as shown in the top view in step 1012) and are arranged into a rectangular array, the recess 204 and the other recesses also have a square shape in their footprint and are arranged into a rectangular array. The pattern formation on the mask 203 may involve lithography process or any other suitable processes. For example, a resist layer may be first deposited (e.g., by spin coating) onto the surface of the mask 203, and lithography is followed to form the openings. The resolution of the lithography is limited by the wavelength of the radiation used. Photolithography tools using deep ultraviolet (DUV) light with wavelengths of approximately 248 and 193 nm, allows minimum feature sizes down to about 50 nm. E-beam lithography tools using electron energy of 1 keV to 50 keV allows minimum feature sizes down to a few nanometers. In step 1013a or step 1013b, the recess 204 and other recesses may be formed into the surface 210a of the semiconductor substrate 210 by etching portions of the semiconductor substrate 210 uncovered by the mask 203 to a desired depth. The height of the portion 207 may be lower or equal to the depth of the recess 204. The recess 204 may have a shape of a frustum, prism, pyramid, cuboid, cubic or cylinder. In example of step 1013a, the recess 204 has a pyramid shape; and in example of step 1013b, the recess 204 has a cuboid shape. The recess 204 may have a smooth surface.

In an embodiment, etching the portions of the semiconductor substrate 210 may be carried out by wet etching, dry etching or a combination thereof. Wet etching is a type of etching processes using liquid-phase etchants. The semiconductor substrate 210 may be immersed in a bath of etchant, and areas not protected by the masks may be removed. The dimensions and shape of the recess 204 may be defined not only by dimensions and shape of the openings of the mask 203, but also material of the semiconductor substrate 210, liquid chemicals or etchants used, etching rate and duration, etc. In an embodiment, the semiconductor substrate 210 may be a silicon substrate, and the recess 204 may be formed by anisotropic wet etching with etchants such as potassium hydroxide (KOH), ethylenediamine pyrocatechol (EDP), tetramethylammonium hydroxide (TMAH), etc. During an anisotropic wet etching of the silicon substrate, liquid etchants may etch the silicon substrate at different rates depending upon the silicon crystalline plane exposed to the etchants, so that the recess 204 with different shapes and dimensions may be formed. In example of step 1013a, when the surface 210a is a (100) silicon crystallographic plane, using wet etchants such as KOH can form a pyramidal-shaped recess 204 with flat and angled etched walls. In example of step 1013b, when the surface 210a is a (110) silicon crystallographic plane, using wet etchants such as KOH can form a cuboidal-shaped recess 204 instead.

In step 1014, the mask 203 may be removed after forming the recess 204 by wet etching, chemical mechanical polishing or some other suitable techniques.

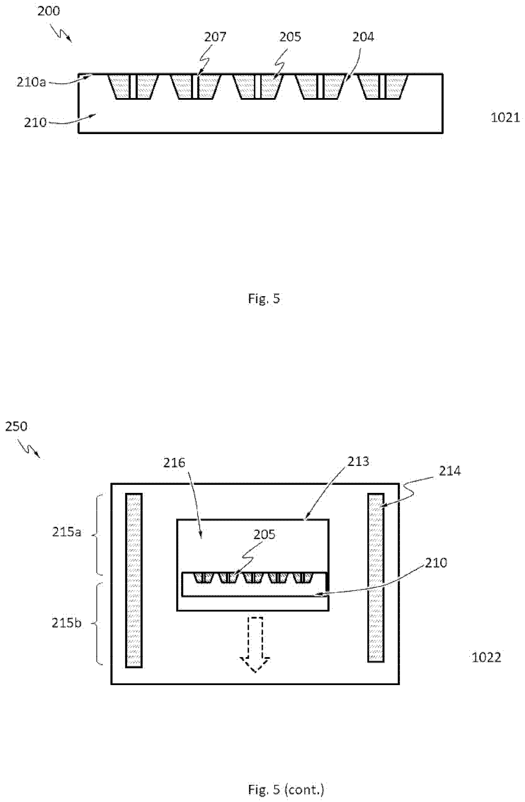

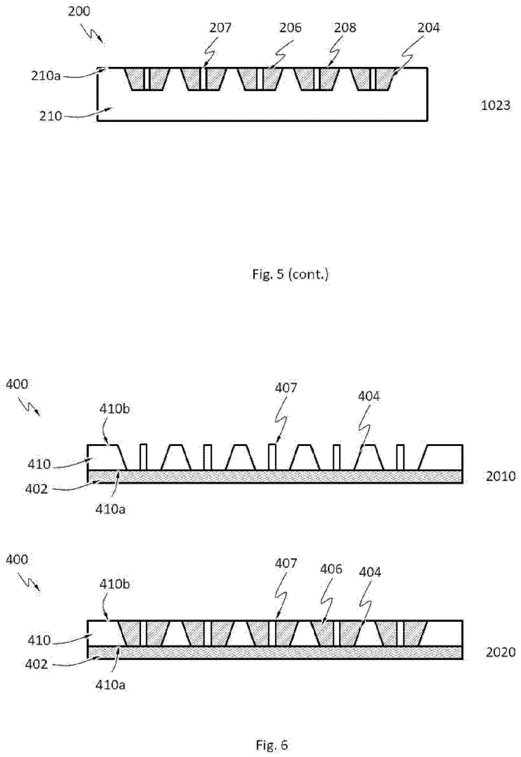

In steps 1021-1023 as shown in Fig. 5, the semiconductor single crystal 206 is formed in the recess 204. The semiconductor single crystal 206 may function as the semiconductor single crystals 106 of the radiation absorption layer 110 in Fig. 2A.

The formation of the semiconductor single crystal 206 may be done by various techniques such as melt-growth technique, traveling heater technique, vapor deposition technique, epitaxial crystallization technique, or any other suitable techniques. A melt-growth technique involves melting semiconductor particles ("precursors") and recrystallizing the melt into a single crystal of the semiconductor. For example, melt-growth techniques such as vertical Bridgeman method and high-pressure Bridgman method may be used to form CdZnTe single crystals. A vapor deposition technique may involve vaporizing suitable semiconductor precursors and forming a semiconductor single crystal on a substrate from the vaporized semiconductor precursors. For example, a CdZnTe single crystal may be formed on a GaAs substrate from vaporized precursors cadmium telluride and zinc telluride. A vapor deposition technique may also be applied together with an epitaxial crystallization technique. For example, a metalorganic vapor-phase epitaxy technique can be used to form an epitaxial layer of CdTe or CdZnTe single crystal on a GaAs or Si substrate, with precursors such as dimethylcadmium (DMCd), dimethylzinc (DMZn) and diethyltellurium (DETe) and hydrogen as a carrier gas. Choice of suitable techniques to form the semiconductor single crystal 206 in the recess 204 depends on the properties of the semiconductor material, the substrate material, etc.

In example of steps 1021-1023, formation of the semiconductor single crystal 206 (CdZnTe single crystal in this example) in the recess 204 is illustrated using a vertical Bridgeman technique. In step 1021, CdZnTe particles 205 (e.g., CnZnTe polycrystal particles) may be deposited into the recess 204. In step 1022 and step 1023, the semiconductor single crystal 206 (shown in step 1023) may be formed by melting the CdZnTe particles 205, and then recrystallizing the melt by cooling the melt in the recess 204. In example of step 1022, the formation process may be carried out in a vertical Bridgeman furnace 250 comprising a growth chamber 213 and heating elements 214. The semiconductor substrate 210 (with the CdZnTe particles 205) is enclosed in the growth chamber 213, which can move relative to the heating elements 214. The temperature profile of the furnace 250 may be controlled by the heating elements 214, so that the furnace 250 may have a hot zone 215a and a gradient zone 215b. The hot zone 215a may have a temperature equal to or above the melting temperature of the CdZnTe particles 205. In the gradient zone 215b, temperature gradually decreases from the temperature in the hot zone 215a to temperatures below the melting temperature. When the growth chamber 213 is in the hot zone 215a, the CdZnTe particles 205 in the recess 204 melt. The melt consists of volatile components to form a vapor above the melt, and the vapor predominantly consists of Cd atoms since Cd has the highest vapor pressure among the CdZnTe melt constituents. To suppress possible leakage of the vapor and to reduce the possibility of chamber rupture, the growth chamber 213 may be pressurized with an inert gas 216 such as argon. As the growth chamber 213 enters the gradient zone 215b from the hot zone 215a (e.g., along a direction shown by a dashed arrow) at a very low speed (e.g., 1-2 mm/h), the melt is cooled and starts to recrystallize from the lower end so that the semiconductor single crystal 206 form progressively in the recess 204. In an embodiment, additional Cd vapor may be sent into the growth chamber 213 to compensate any Cd loss and provide a fine control of molar concentrations of Cd and Zn of the semiconductor single crystal 206. In an embodiment, the formation process can also be carried out in a horizontal geometry.

The yield of the semiconductor single crystal 206 (i.e., the probability that the recess 204 has only the semiconductor single crystal 206) may depend on the formation technique applied, properties of the semiconductor material, formation conditions, etc. In example of step 1022, the yield of the semiconductor single crystal 206 may be tuned by the cooling rate, which can be adjusted by the moving speed of the growth chamber 213, length of the gradient zone 215b, etc.

In step 1023, the surface 210a of the semiconductor substrate 210 may be polished after the formation of the semiconductor single crystal 206, by wet etching, chemical mechanical polishing or some other suitable techniques. Alternatively, a surface 208 of each of the semiconductor single crystal 206 may be polished so that the surface 210a is coextensive with surface 208. The surfaces 210a and 208 may be flat and smooth after polishing.

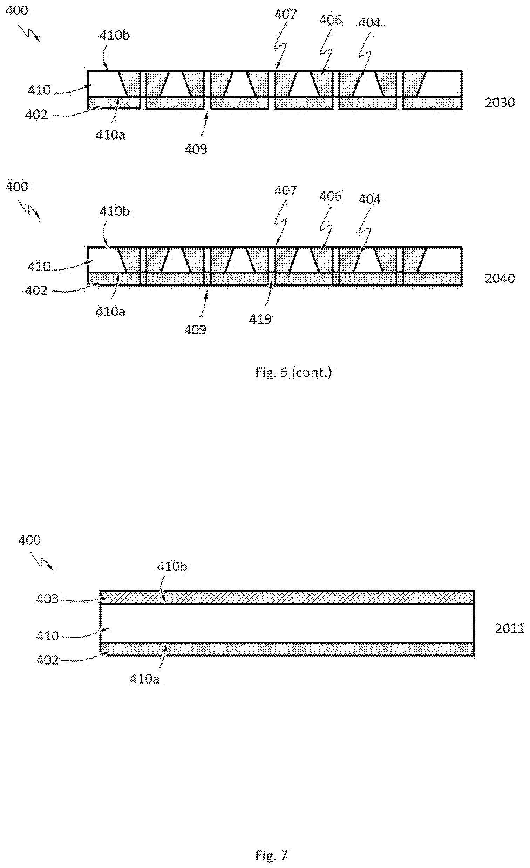

Fig. 6 schematically illustrates a process of forming a radiation absorption layer 400, according to an embodiment.

In step 2010, a through hole 404 is formed in a semiconductor layer 410, where the semiconductor layer 410 is supported directly on an electrical insulator layer 402. A portion 407 of the semiconductor layer 410 remains in and is surrounded by the through hole 404. Because the through hole 404 extends through the entire thickness of the semiconductor layer 410, the portion 407 and the rest of the semiconductor layer 410 are electrically isolated at the conclusion of step 2010. The electrical insulator layer 402 may function as the electrical insulator layer 198 in Fig. 2B. The through hole 404 may function as the through hole 194 in Fig. 2B. The portion 407 may function as the portion 197 in Fig. 2B.

In step 2020, a semiconductor single crystal 406 is formed in the through hole 404. The semiconductor single crystal 406 has a different composition from the semiconductor layer 410. The semiconductor single crystal 406 may function as the semiconductor single crystal 196 in Fig. 2B.

In step 2030, an opening 409 is formed through the electrical insulator layer 402 so that the portion 407 is exposed in the opening 409.

In step 2040, an electrode 419 is formed in the opening 409. The electrode 419 is in electrical contact to the portion 407. The electrode may function as the electrode 199 in Fig. 2B.

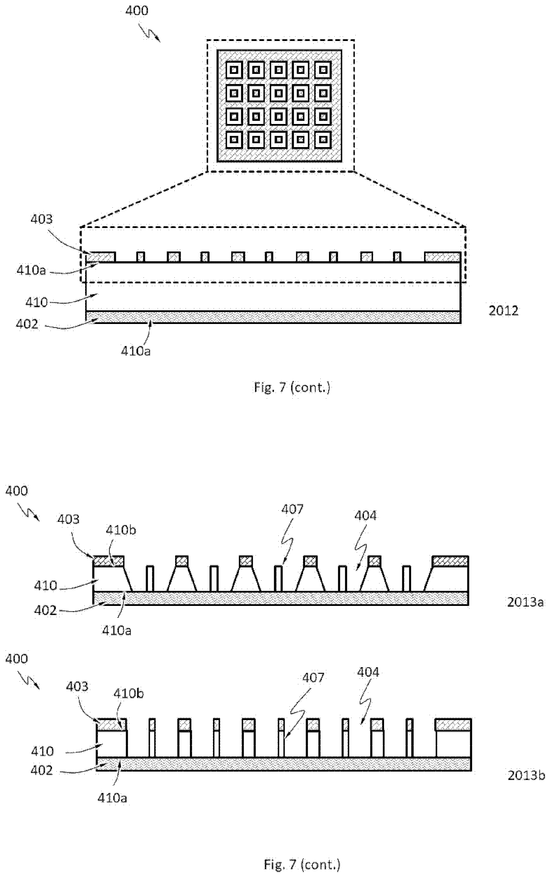

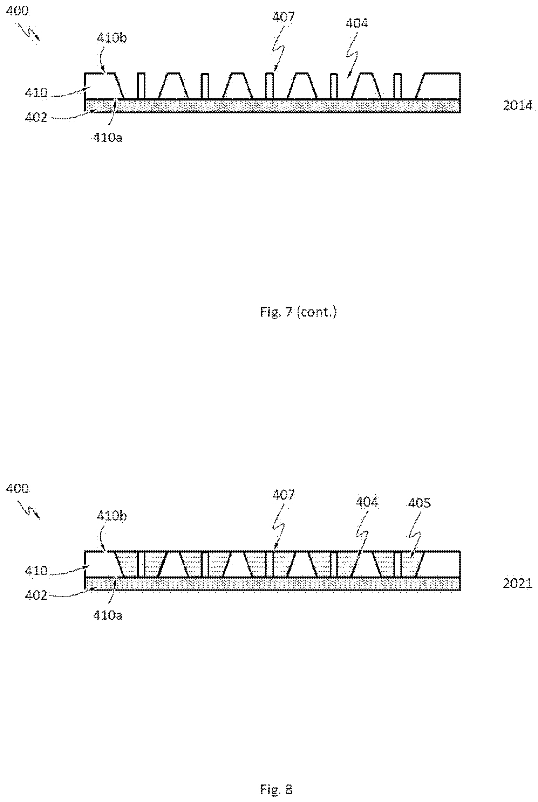

In an embodiment, forming the through hole 404 in a semiconductor layer 410 may comprise forming a mask 403 on the semiconductor substrate 210 and etching an area of the semiconductor layer 410 uncovered by the mask 403, as shown in step 2011 - 2014 of Fig. 7. The mask 403 may be formed onto a surface 410b of the semiconductor layer 410 and the semiconductor layer 410 may include a semiconductor material such as, silicon, germanium, GaAs, or a combination thereof. The mask 403 may serve as an etch mask for forming the through hole 404 and other through holes as shown in step 2013a or step 2013b. The mask 403 may comprise a material such as silicon dioxide, silicon nitride, carbon, or metals (e.g., aluminum, chromium). The thickness of the mask 403 may be determined according to the depth of the through hole 404 and the other through holes and etching selectivity (i.e., ratio of etching rates of the mask 403 and the semiconductor layer 410). In an embodiment, the mask 403 may have a thickness of a few microns. The mask 403 may be formed onto the surface 410b by various techniques, such as physical vapor deposition, chemical vapor deposition, spin coating, sputtering or any other suitable processes.

In step 2012, the mask 403 is patterned to have openings in which the semiconductor layer 410 is exposed, shown from a cross-sectional view. Shapes and locations of the openings correspond to the footprint shapes and locations of the through hole 404 and the other through holes to be formed in step 2013a or step 2013b. If the openings have a square shape (as shown in the top view in step 2012) and are arranged into a rectangular array, the through hole 404 and the other through holes also have a square shape in their footprint and are arranged into a rectangular array. The pattern formation on the mask 403 may involve lithography process or any other suitable processes. For example, a resist layer may be first deposited (e.g., by spin coating) onto the surface of the mask 403, and lithography is followed to form the openings. The resolution of the lithography is limited by the wavelength of the radiation used. Photolithography tools using deep ultraviolet (DUV) light with wavelengths of approximately 248 and 193 nm, allows minimum feature sizes down to about 50 nm. E-beam lithography tools using electron energy of 1 keV to 50 keV allows minimum feature sizes down to a few nanometers.

In step 2013a or step 2013b, the through hole 404 and the other through holes may be formed into the surface 410b of the semiconductor layer 410 by etching portions of the semiconductor layer 410 uncovered by the mask 403 to a desired depth. The height of the portion 407 may be lower or equal to the depth of the through hole 404. The through hole 404 may have a shape of a frustum, prism, pyramid, cuboid, cubic or cylinder. In example of step 2013a, the through hole 404 has a pyramid shape; and in example of step 2013b, the through hole 404 has a cuboid shape. The through hole 404 may have a smooth surface.

In an embodiment, etching the portions of the semiconductor layer 410 may be carried out by wet etching, dry etching or a combination thereof. Wet etching is a type of etching processes using liquid-phase etchants. The semiconductor layer 410 may be immersed in a bath of etchant, and areas not protected by the masks may be removed. The dimensions and shape of the through hole 404 and the other through holes may be defined not only by dimensions and shape of the openings of the mask 403, but also material of the semiconductor layer 410, liquid chemicals or etchants used, etching rate and duration, etc. In an embodiment, the semiconductor layer 410 may be a silicon substrate, and the through hole 404 and the other through holes may be formed by anisotropic wet etching with etchants such as potassium hydroxide (KOH), ethylenediamine pyrocatechol (EDP), tetramethylammonium hydroxide (TMAH), etc. During an anisotropic wet etching of the silicon substrate, liquid etchants may etch the silicon substrate at different rates depending upon the silicon crystalline plane exposed to the etchants, so that through holes with different shapes and dimensions may be formed. In example of step 2013a, when the surface 410b is a (100) silicon crystallographic plane, using wet etchants such as KOH can form pyramidal-shaped through hole 404 with flat and angled etched walls. In example of step 2013b, when the surface 410b is a (110) silicon crystallographic plane, using wet etchants such as KOH can form cuboidal-shaped through hole 404 instead.

In step 2014, the mask 403 may be removed after forming the through hole 404 and the other through holes by wet etching, chemical mechanical polishing or some other suitable techniques.

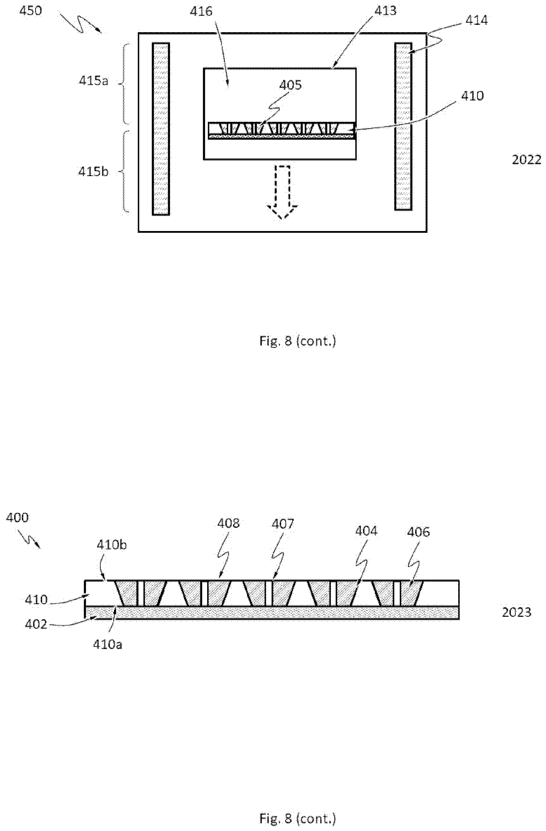

In steps 2021 -2023 as shown in Fig. 8, semiconductor single crystals (e.g., 406 in step 1023) are formed in the through hole 404 and the other through holes. The semiconductor single crystals (e.g., 406 in step 1023) may function as the semiconductor single crystals 196 of the radiation absorption layer 110 in Fig. 2B.

The formation of the semiconductor single crystal 406 may be done by various techniques such as melt-growth technique, traveling heater technique, vapor deposition technique, epitaxial crystallization technique, or any other suitable techniques. A melt-growth technique involves melting semiconductor particles ("precursors") and recrystallizing the melt into a single crystal of the semiconductor. For example, melt-growth techniques such as vertical Bridgeman method and high-pressure Bridgman method may be used to form CdZnTe single crystals. A vapor deposition technique may involve vaporizing suitable semiconductor precursors and forming a semiconductor single crystal on a substrate from the vaporized semiconductor precursors. For example, a CdZnTe single crystal may be formed on a GaAs substrate from vaporized precursors cadmium telluride and zinc telluride. A vapor deposition technique may also be applied together with an epitaxial crystallization technique. For example, a metalorganic vapor-phase epitaxy technique can be used to form an epitaxial layer of CdTe or CdZnTe single crystal on a GaAs or Si substrate, with precursors such as dimethylcadmium (DMCd), dimethylzinc (DMZn) and diethyltellurium (DETe) and hydrogen as a carrier gas. Choice of suitable techniques to form the semiconductor single crystal 406 in the through hole 404 and the other through holes depends on the properties of the semiconductor material, the substrate material, etc.

In example of steps 2021-2023, formation of the semiconductor single crystal 406 (CdZnTe in this example) in the through hole 404 and the other through holes is illustrated using a vertical Bridgeman technique. In step 2021, CdZnTe particles 405 (e.g., CnZnTe polycrystal particles) may be deposited into the through hole 404 and the other through holes. In step 2022 and step 2023, the semiconductor single crystal 406 (shown in step 2023) may be formed by melting the CdZnTe particles 405, and then recrystallizing the melt by cooling the melt in the through hole 404 and the other through holes. In example of step 2022, the formation process may be carried out in a vertical Bridgeman furnace 450 comprising a growth chamber 413 and heating elements 414. The semiconductor layer 410 (with the CdZnTe particles 405) is enclosed in the growth chamber 413, which can move relative to the heating elements 414. The temperature profile of the furnace 450 may be controlled by the heating elements 414, so that the furnace 450 may have a hot zone 415a and a gradient zone 415b. The hot zone 415a may have a temperature equal to or above the melting temperature of the CdZnTe particles 405. In the gradient zone 415b, temperature gradually decreases from the temperature in the hot zone 415a to temperatures below the melting temperature. When the growth chamber 413 is in the hot zone 415a, the CdZnTe particles 405 in the through hole 404 and the other through holes melt. The melt consists of volatile components to form a vapor above the melt, and the vapor predominantly consists of Cd atoms since Cd has the highest vapor pressure among the CdZnTe melt constituents. To suppress possible leakage of the vapor and to reduce the possibility of chamber rupture, the growth chamber 413 may be pressurized with an inert gas 416 such as argon. As the growth chamber 413 enters the gradient zone 415b from the hot zone 415a (e.g., along a direction shown by a dashed arrow) at a very low speed (e.g., 1-2 mm/h), the melt is cooled and starts to recrystallize from the lower end so that the semiconductor single crystals 406 form progressively in the through hole 404 and the other through holes. In an embodiment, additional Cd vapor may be sent into the growth chamber 413 to compensate any Cd loss and provide a fine control of molar concentrations of Cd and Zn of the semiconductor single crystals 406. In an embodiment, the formation process can also be carried out in a horizontal geometry. The semiconductor single crystals 406 can be other single crystals such as cadmium telluride (CdTe) single crystals.

The yield of the semiconductor single crystal 406 (i.e., the probability that the through hole 404 has only the semiconductor single crystal 406) may depend on the formation technique applied, properties of the semiconductor material, formation conditions, etc. In example of step 2022, the yield of the semiconductor single crystal 406 may be tuned by the cooling rate, which can be adjusted by the moving speed of the growth chamber 413, length of the gradient zone 415b, etc.

The semiconductor single crystals 406 is shown in step 2023. In an embodiment, after forming the semiconductor single crystal 406, the through hole 404 does not contain other semiconductor material except the semiconductor single crystal 406. The through hole 404 does not contain a semiconductor polycrystal.

The surface 410b of the semiconductor layer 410 may be polished after the formation of the semiconductor single crystals 406, by wet etching, chemical mechanical polishing or some other suitable techniques. Alternatively, a surface 408 of each of the semiconductor single crystal 406 may be polished so that the surface 410b is coextensive with surface 408. The surfaces 410b and 408 may be flat and smooth after polishing.

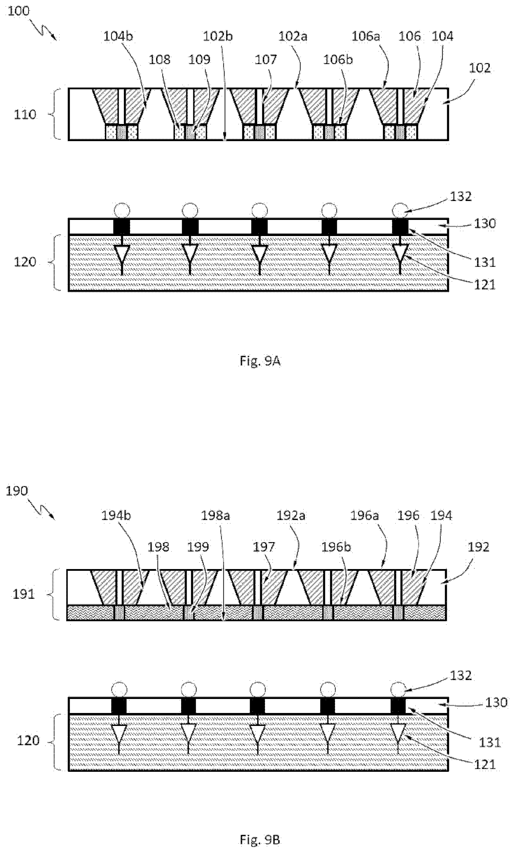

Fig. 9A schematically illustrates a process of bonding the semiconductor substrate 102 and an electronics layer 120 as shown in Fig. 2A. The electronics layer 120 may comprise an electronic system that is electronically connected to the second doped semiconductor region 109 and configured to process an electrical signal generated in the radiation absorption layer 110.

Fig. 9B schematically illustrates a process of bonding the electrical insulator layer 198 to an electronics layer 120 as shown in Fig. 2B. The electronics layer 120 may comprise an electronic system 121 electrically connected to the electrode 199 and configured to process an electrical signal generated in the radiation absorption layer 191.

The second doped semiconductor region 109 or the electrode 199 as shown may bond to each of the vias 131 by a suitable technique such as direct bonding or flip chip bonding.

Direct bonding is a wafer bonding process without any additional intermediate layers (e.g., solder bumps). The bonding process is based on chemical bonds between two surfaces. Direct bonding may be at elevated temperature but not necessarily so.

Flip chip bonding uses solder bumps 132 deposited onto contact pads (e.g., the second doped semiconductor region 109 or electrode 199, or contacting surfaces of the vias 131). Either the radiation absorption layer 110 or 191, or the electronics layer 120 is flipped over and the second doped semiconductor region 109 or electrode 199 are aligned to the vias 131. The solder bumps 132 may be melted to solder the second doped semiconductor region 109 or electrode 199 and the vias 131 together. Any void space among the solder bumps 132 may be filled with an insulating material.

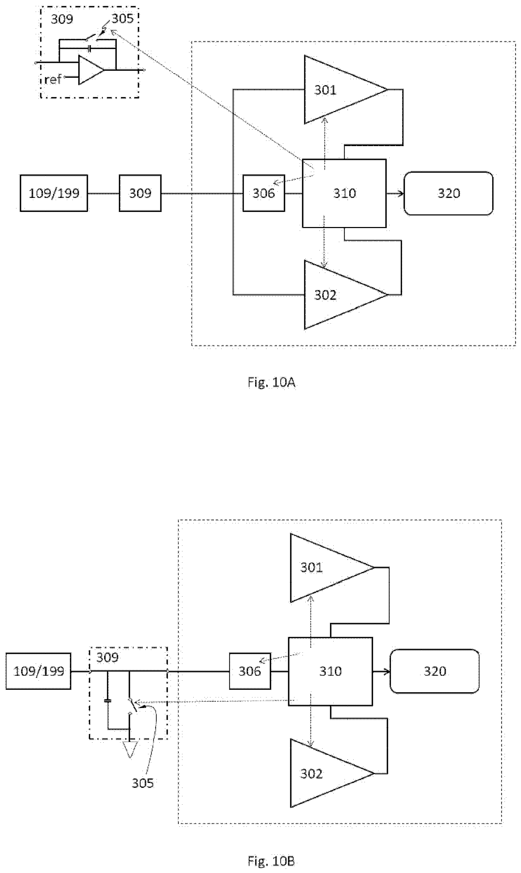

Fig. 10A and Fig. 10B each show a component diagram of the electronic system 121, according to an embodiment. The electronic system 121 may include a first voltage comparator 301, a second voltage comparator 302, a counter 320, a switch 305, a voltmeter 306 and a controller 310.

The first voltage comparator 301 is configured to compare the voltage of an electrode (e.g., the second doped semiconductor region 109 on the semiconductor single crystal 106 or the electrode 199 on the semiconductor single crystal 106 196) to a first threshold. The first voltage comparator 301 may be configured to monitor the voltage directly, or calculate the voltage by integrating an electric current flowing through the electrode over a period of time. The first voltage comparator 301 may be controllably activated or deactivated by the controller 310. The first voltage comparator 301 may be a continuous comparator. Namely, the first voltage comparator 301 may be configured to be activated continuously, and monitor the voltage continuously. The first voltage comparator 301 configured as a continuous comparator reduces the chance that the electronic system 121 missing signals generated by an incident radiation particle. The first voltage comparator 301 configured as a continuous comparator is especially suitable when the incident radiation intensity is relatively high. The first voltage comparator 301 may be a clocked comparator, which has the benefit of lower power consumption. The first voltage comparator 301 configured as a clocked comparator may cause the electronic system 121 to miss signals generated by some incident radiation particles. When the incident radiation intensity is low, the chance of missing an incident radiation particle is low because the time interval between two successive radiation particles is relatively long. Therefore, the first voltage comparator 301 configured as a clocked comparator is especially suitable when the incident radiation intensity is relatively low. The first threshold may be 5-10%, 10%-20%, 20-30%, 30-40% or 40-50% of the maximum voltage one incident radiation particle may generate in the semiconductor single crystal 106 or 196. The maximum voltage may depend on the energy of the incident radiation particle (i.e., the wavelength of the incident radiation), the material of the radiation absorption layer 110 or 191, and other factors. For example, the first threshold may be 50 mV, 100 mV, 150 mV, or 200 mV.

The second voltage comparator 302 is configured to compare the voltage to a second threshold. The second voltage comparator 302 may be configured to monitor the voltage directly, or calculate the voltage by integrating an electric current flowing through the electrode over a period of time. The second voltage comparator 302 may be a continuous comparator. The second voltage comparator 302 may be controllably activated or deactivated by the controller 310. When the second voltage comparator 302 is deactivated, the power consumption of the second voltage comparator 302 may be less than 1%, less than 5%, less than 10% or less than 20% of the power consumption when the second voltage comparator 302 is activated. The absolute value of the second threshold is greater than the absolute value of the first threshold. As used herein, the term "absolute value" or "modulus" $|x|$ of a real number $x$ is the non-negative value of $x$ without regard to its sign. Namely, $|x| =$

$$\begin{cases} x, \text{if } x \geq 0 \\ -x, \text{if } x \leq 0 \end{cases}$$

. The second threshold may be 200%-300% of the first threshold. The second threshold may be at least 50% of the maximum voltage one incident radiation particle may generate in the semiconductor single crystal 106 or 196. For example, the second threshold may be 100 mV, 150 mV, 200 mV, 250 mV or 300 mV. The second voltage comparator 302 and the first voltage comparator 310 may be the same component. Namely, the system 121 may have one voltage comparator that can compare a voltage with two different thresholds at different times.

The first voltage comparator 301 or the second voltage comparator 302 may include one or more op-amps or any other suitable circuitry. The first voltage comparator 301 or the second voltage comparator 302 may have a high speed to allow the electronic system 121 to operate under a high flux of incident radiation. However, having a high speed is often at the cost of power consumption.

The counter 320 is configured to register a number of radiation particles reaching the semiconductor single crystal 106 or 196. The counter 320 may be a software component (e.g., a number stored in a computer memory) or a hardware component (e.g., a 4017 IC and a 7490 IC).

The controller 310 may be a hardware component such as a microcontroller and a microprocessor. The controller 310 is configured to start a time delay from a time at which the first voltage comparator 301 determines that the absolute value of the voltage equals or exceeds the absolute value of the first threshold (e.g., the absolute value of the voltage increases from below the absolute value of the first threshold to a value equal to or above the absolute value of the first threshold). The absolute value is used here because the voltage may be negative or positive, depending on the voltage of which electrode (e.g., a cathode or an anode) is used. The controller 310 may be configured to keep deactivated the second voltage comparator 302, the counter 320 and any other circuits the operation of the first voltage comparator 301 does not require, before the time at which the first voltage comparator 301 determines that the absolute value of the voltage equals or exceeds the absolute value of the first threshold. The time delay may expire before or after the voltage becomes stable, i.e., the rate of change of the voltage is substantially zero. The phase "the rate of change of the voltage is substantially zero" means that temporal change of the voltage is less than 0.1%/ns. The phase "the rate of change of the voltage is substantially non-zero" means that temporal change of the voltage is at least 0.1%/ns.

The controller 310 may be configured to activate the second voltage comparator during (including the beginning and the expiration) the time delay. In an embodiment, the controller 310 is configured to activate the second voltage comparator at the beginning of the time delay. The term "activate" means causing the component to enter an operational state (e.g., by sending a signal such as a voltage pulse or a logic level, by providing power, etc.). The term "deactivate" means causing the component to enter a non-operational state (e.g., by sending a signal such as a voltage pulse or a logic level, by cut off power, etc.). The operational state may have higher power consumption (e.g., 10 times higher, 100 times higher, 1000 times higher) than the non-operational state. The controller 310 itself may be deactivated until the output of the first voltage comparator 301 activates the controller 310 when the absolute value of the voltage equals or exceeds the absolute value of the first threshold.

The controller 310 may be configured to cause the number registered by the counter 320 to increase by one, if, during the time delay, the second voltage comparator 302 determines that the absolute value of the voltage equals or exceeds the absolute value of the second threshold.

The controller 310 may be configured to cause the voltmeter 306 to measure the voltage upon expiration of the time delay. The controller 310 may be configured to connect the electrode to an electrical ground, so as to reset the voltage and discharge any charge carriers accumulated on the electrode. In an embodiment, the electrode is connected to an electrical ground after the expiration of the time delay. In an embodiment, the electrode is connected to an electrical ground for a finite reset time period. The controller 310 may connect the electrode to the electrical ground by controlling the switch 305. The switch may be a transistor such as a field-effect transistor (FET).

In an embodiment, the system 121 has no analog filter network (e.g., a RC network). In an embodiment, the system 121 has no analog circuitry.

The voltmeter 306 may feed the voltage it measures to the controller 310 as an analog or digital signal.

The electronic system 121 may include a capacitor module 309 electrically connected to the electrode, wherein the capacitor module is configured to collect charge carriers from the electrode. The capacitor module can include a capacitor in the feedback path of an amplifier. The amplifier configured as such is called a capacitive transimpedance amplifier (CTIA). CTIA has high dynamic range by keeping the amplifier from saturating and improves the signal-to-noise ratio by limiting the bandwidth in the signal path. Charge carriers from the electrode accumulate on the capacitor over a period of time ("integration period") (e.g., as shown in Fig. 7, between $t_0$ to $t_1$, or $t_1$-$t_2$). After the integration period has expired, the capacitor voltage is sampled and then reset by a reset switch. The capacitor module can include a capacitor directly connected to the electrode.

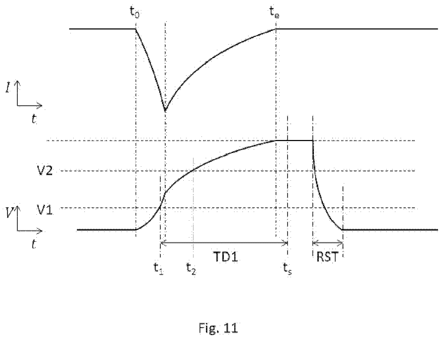

Fig. 11 schematically shows a temporal change of the electric current flowing through the electrode (upper curve) caused by charge carriers generated by a radiation particle incident on the semiconductor single crystal 106 or 196, and a corresponding temporal change of the voltage of the electrode (lower curve). The voltage may be an integral of the electric current with respect to time. At time $t_0$, the radiation particle hits the semiconductor single crystal 106 or 196, charge carriers start being generated in the semiconductor single crystal 106 or 196, electric current starts to flow through the electrode of the semiconductor single crystal 106 or 196, and the absolute value of the voltage of the electrode or electrode starts to increase. At time $t_1$, the first voltage comparator 301 determines that the absolute value of the voltage equals or exceeds the absolute value of the first threshold V1, and the controller 310 starts the time delay TD1 and the controller 310 may deactivate the first voltage comparator 301 at the beginning of TD1. If the controller 310 is deactivated before $t_1$, the controller 310 is activated at $t_1$. During TD1, the controller 310 activates the second voltage comparator 302. The term "during" a time delay as used here means the beginning and the expiration (i.e., the end) and any time in between. For example, the controller 310 may activate the second voltage comparator 302 at the expiration of TD1. If during TD1, the second voltage comparator 302 determines that the absolute value of the voltage equals or exceeds the absolute value of the second threshold at time $t_2$, the controller 310 causes the number registered by the counter 320 to increase by one. At time $t_e$, all charge carriers generated by the radiation particle drift out of the radiation absorption layer 110. At time $t_s$, the time delay TD1 expires. In the example of Fig. 11, time $t_s$ is after time $t_e$; namely TD1 expires after all charge carriers generated by the radiation particle drift out of the radiation absorption layer 110 or 191. The rate of change of the voltage is thus substantially zero at $t_s$. The controller 310 may be configured to deactivate the second voltage comparator 302 at expiration of TD1 or at $t_2$, or any time in between.

The controller 310 may be configured to cause the voltmeter 306 to measure the voltage upon expiration of the time delay TD1. In an embodiment, the controller 310 causes the voltmeter 306 to measure the voltage after the rate of change of the voltage becomes substantially zero after the expiration of the time delay TD1. The voltage at this moment is proportional to the amount of charge carriers generated by a radiation particle, which relates to the energy of the radiation particle. The controller 310 may be configured to determine the energy of the radiation particle based on voltage the voltmeter 306 measures. One way to determine the energy is by binning the voltage. The counter 320 may have a sub-counter for each bin. When the controller 310 determines that the energy of the radiation particle falls in a bin, the controller 310 may cause the number registered in the sub-counter for that bin to increase by one. Therefore, the electronic system 121 may be able to detect a radiation image and may be able to resolve radiation particle energies of each radiation particle.

After TD1 expires, the controller 310 connects the electrode to an electric ground for a reset period RST to allow charge carriers accumulated on the electrode to flow to the ground and reset the voltage. After RST, the electronic system 121 is ready to detect another incident radiation particle. Implicitly, the rate of incident radiation particles the electronic system 121 can handle in the example of Fig. 11 is limited by 1/(TD1+RST). If the first voltage comparator 301 has been deactivated, the controller 310 can activate it at any time before RST expires. If the controller 310 has been deactivated, it may be activated before RST expires.

While various aspects and embodiments have been disclosed herein, other aspects and embodiments will be apparent to those skilled in the art. The various aspects and embodiments disclosed herein are for purposes of illustration and are not intended to be limiting, with the scope being defined by the appended claims.

## Claims

1. A method comprising:

   forming (1010) a recess (204) into a semiconductor substrate (210), wherein a portion (207) of the semiconductor substrate extends into the recess and is surrounded by the recess; forming (1020) a semiconductor single crystal (206) in the recess, the semiconductor single crystal having a different composition from the semiconductor substrate; forming (1030) a first doped semiconductor region (218) in the semiconductor substrate; forming (1040) a second doped semiconductor region (219) in the semiconductor substrate; wherein the first doped semiconductor region and the second doped semiconductor region form a p-n junction that separates the portion from the rest of the semiconductor substrate.

2. The method of claim 1, wherein the first doped semiconductor region surrounds the second doped semiconductor region.

3. The method of claim 1, wherein the second doped semiconductor region is in electrical contact with the portion.

4. The method of claim 1, wherein the first doped semiconductor region extends from a surface of the semiconductor substrate to an interface between the semiconductor single crystal and the semiconductor substrate.

5. The method of claim 1, wherein the second doped semiconductor region is coextensive with the first doped semiconductor region.

6. The method of claim 1, further comprising polishing the semiconductor substrate or the semiconductor single crystal so that the semiconductor single crystal and the semiconductor substrate are coextensive.

7. The method of claim 1, wherein the recess does not contain other semiconductor material except the semiconductor single crystal, after forming the semiconductor single crystal.

8. The method of claim 1, wherein the recess does not contain a semiconductor polycrystal, after forming the semiconductor single crystal.

9. The method of claim 1, further comprising bonding the semiconductor substrate to another substrate comprising an electronic system therein or thereon, wherein the electronic system is electrically connected to the second doped semiconductor region and configured to process an electrical signal generated in the semiconductor substrate.

10. A method comprising:

forming (2010) a through hole (404) in a semiconductor layer (410) supported directly on an electrical insulator layer (402), wherein a portion (407) of the semiconductor layer remains in and is surrounded by the through hole;
forming (2020) a semiconductor single crystal (406) in the through hole, the semiconductor single crystal having a different composition from the semiconductor layer;
forming (2030) an opening (409) through the electrical insulator layer so that the portion is exposed in the opening;
forming (2040) an electrode (419) in the opening, the electrode being in electrical contact to the portion.

11. The method of claim 10, wherein forming the through hole comprises forming a mask on the semiconductor layer and etching an area of the semiconductor layer uncovered by the mask, the method further comprising polishing the semiconductor layer or the semiconductor single crystal so that the semiconductor single crystal and the semiconductor layer are coextensive.

12. The method of claim 10, wherein the through hole does not contain other semiconductor material except the semiconductor single crystal, after forming the semiconductor single crystal.

13. The method of claim 10, wherein the through hole does not contain a semiconductor polycrystal, after forming the semiconductor single crystal.

14. The method of claim 10, further comprising bonding the electrical insulator layer to an electronic layer comprising an electronic system electrically connected to the electrode and configured to process an electrical signal generated in the semiconductor layer.

15. A radiation detector manufactured in accordance with the method of any one of claims 1-14.

**Patentansprüche**

1. Verfahren, umfassend:

Bilden (1010) einer Aussparung (204) in ein Halbleitersubstrat (210), wobei sich ein Abschnitt (207) des Halbleitersubstrats in die Aussparung erstreckt und von der Aussparung umgeben ist;
Bilden (1020) eines Halbleitereinkristalls (206) in der Aussparung, wobei der Halbleitereinkristall eine unterschiedliche Zusammensetzung als das Halbleitersubstrat aufweist;
Bilden (1030) eines ersten dotierten Halbleiterbereichs (218) in dem Halbleitersubstrat;
Bilden (1040) eines zweiten dotierten Halbleiterbereichs (219) in dem Halbleitersubstrat;
wobei der erste dotierte Halbleiterbereich und der zweite dotierte Halbleiterbereich einen p-n-Übergang bilden, der den Abschnitt von dem Rest des Halbleitersubstrats trennt.

2. Verfahren nach Anspruch 1, wobei der erste dotierte Halbleiterbereich den zweiten dotierten Halbleiterbereich umgibt.

3. Verfahren nach Anspruch 1, wobei der zweite dotierte Halbleiterbereich in elektrischem Kontakt mit dem Abschnitt steht.

4. Verfahren nach Anspruch 1, wobei sich der erste dotierte Halbleiterbereich von einer Oberfläche des Halbleitersubstrats zu einer Grenzfläche zwischen dem Halbleitereinkristall und dem Halbleitersubstrat erstreckt.

5. Verfahren nach Anspruch 1, wobei der zweite dotierte Halbleiterbereich mit dem ersten dotierten Halbleiterbereich koextensiv ist.

**6.** Verfahren nach Anspruch 1, das ferner das Polieren des Halbleitersubstrats oder des Halbleitereinkristalls derart umfasst, dass der Halbleitereinkristall und das Halbleitersubstrat koextensiv sind.

**7.** Verfahren nach Anspruch 1, wobei die Aussparung mit Ausnahme des Halbleitereinkristalls nach dem Bilden des Halbleitereinkristalls kein anderes Halbleitermaterial enthält.

**8.** Verfahren nach Anspruch 1, wobei die Aussparung nach dem Bilden des Halbleitereinkristalls keinen Halbleiterpolykristall enthält.

**9.** Verfahren nach Anspruch 1, das ferner ein Binden des Halbleitersubstrats an ein anderes Substrat umfasst, das ein elektronisches System darin oder darauf umfasst, wobei das elektronische System elektrisch mit dem zweiten dotierten Halbleiterbereich verbunden und dazu konfiguriert ist, ein elektrisches Signal, das in dem Halbleitersubstrat erzeugt wird, zu verarbeiten.

**10.** Verfahren, umfassend:

Bilden (2010) eines Durchgangslochs (404) in einer Halbleiterschicht (410), die direkt auf einer elektrischen Isolatorschicht (402) getragen wird, wobei ein Abschnitt (407) der Halbleiterschicht in dem Durchgangsloch verbleibt und von diesem umgeben ist;
Bilden (2020) eines Halbleitereinkristalls (406) in dem Durchgangsloch, wobei der Halbleitereinkristall eine unterschiedliche Zusammensetzung als die Halbleiterschicht aufweist;
Bilden (2030) einer Öffnung (409) durch die elektrische Isolatorschicht derart, dass der Abschnitt in der Öffnung freiliegt;
Bilden (2040) einer Elektrode (419) in der Öffnung, wobei die Elektrode in elektrischem Kontakt mit dem Abschnitt steht.

**11.** Verfahren nach Anspruch 10, wobei das Bilden des Durchgangslochs das Bilden einer Maske auf der Halbleiterschicht und das Ätzen einer Fläche der Halbleiterschicht, die von der Maske freigelegt wird, umfasst, wobei das Verfahren ferner das Polieren der Halbleiterschicht oder des Halbleitereinkristalls derart umfasst, dass der Halbleitereinkristall und die Halbleiterschicht koextensiv sind.

**12.** Verfahren nach Anspruch 10, wobei das Durchgangsloch mit Ausnahme des Halbleitereinkristalls nach dem Bilden des Halbleitereinkristalls kein anderes Halbleitermaterial enthält.

**13.** Verfahren nach Anspruch 10, wobei das Durchgangsloch nach dem Bilden des Halbleitereinkristalls keinen Halbleiterpolykristall enthält.

**14.** Verfahren nach Anspruch 10, das ferner das Binden der elektrischen Isolatorschicht an eine elektronische Schicht umfasst, die ein elektronisches System umfasst, das elektrisch mit der Elektrode verbunden und dazu konfiguriert ist, ein in der Halbleiterschicht erzeugtes elektrisches Signal zu verarbeiten.

**15.** Strahlungsdetektor, der gemäß dem Verfahren nach einem der Ansprüche 1-14 hergestellt ist.

**Revendications**

**1.** Procédé comprenant les étapes consistant à :

former (1010) un évidement (204) dans un substrat semi-conducteur (210), dans lequel une partie (207) du substrat semi-conducteur s'étend dans l'évidement et est entourée par l'évidement ;
former (1020) un monocristal semi-conducteur (206) dans l'évidement, le monocristal semi-conducteur ayant une composition différente par rapport au substrat semi-conducteur ;
former (1030) une première région semi-conductrice dopée (218) dans le substrat semi-conducteur ;
former (1040) une seconde région semi-conductrice dopée (219) dans le substrat semi-conducteur ;
dans lequel la première région semi-conductrice dopée et la seconde région semi-conductrice dopée forment une jonction p-n qui sépare la partie du reste du substrat semi-conducteur.

**2.** Procédé selon la revendication 1, dans lequel la première région semi-conductrice dopée entoure la seconde région semi-conductrice dopée.

**3.** Procédé selon la revendication 1, dans lequel la seconde région semi-conductrice dopée est en contact électrique avec la partie.

**4.** Procédé selon la revendication 1, dans lequel la première région semi-conductrice dopée s'étend d'une surface du substrat semi-conducteur à une interface entre le monocristal semi-conducteur et le substrat semi-conducteur.

**5.** Procédé selon la revendication 1, dans lequel la seconde région semi-conductrice dopée est coextensive à la première région semi-conductrice dopée.

**6.** Procédé selon la revendication 1, comprenant en outre le polissage du substrat semi-conducteur ou du monocristal semi-conducteur de sorte que le monocristal semi-conducteur et le substrat semi-conducteur soient coextensifs.

7. Procédé selon la revendication 1, dans lequel l'évidement ne contient pas d'autres matériaux semi-conducteurs à l'exception du monocristal semi-conducteur, après la formation du monocristal semi-conducteur.

8. Procédé selon la revendication 1, dans lequel l'évidement ne contient pas de polycristaux semi-conducteurs, après la formation du monocristal semi-conducteur.

9. Procédé selon la revendication 1, comprenant en outre la liaison du substrat semi-conducteur à un autre substrat comprenant un système électronique à l'intérieur ou sur celui-ci, dans lequel le système électronique est connecté électriquement à la seconde région semi-conductrice dopée et configuré pour traiter un signal électrique généré dans le substrat semi-conducteur.

10. Procédé comprenant les étapes consistant à :

> former (2010) un trou traversant (404) dans une couche semi-conductrice (410) supportée directement sur une couche d'isolant électrique (402), dans lequel une partie (407) de la couche semi-conductrice reste dans et est entourée par le trou traversant ;
> former (2020) un monocristal semi-conducteur (406) dans le trou traversant, le monocristal semi-conducteur ayant une composition différente par rapport à la couche semi-conductrice ;
> former (2030) une ouverture (409) à travers la couche d'isolant électrique de sorte que la partie soit exposée dans l'ouverture ;
> former (2040) une électrode (419) dans l'ouverture, l'électrode étant en contact électrique avec la partie.

11. Procédé selon la revendication 10, dans lequel la formation du trou traversant comprend la formation d'un masque sur la couche semi-conductrice et la gravure d'une zone de la couche semi-conductrice exposée par le masque, le procédé comprenant en outre le polissage de la couche semi-conductrice ou du monocristal semi-conducteur de sorte que le monocristal semi-conducteur et la couche semi-conductrice soient coextensifs.

12. Procédé selon la revendication 10, dans lequel le trou traversant ne contient pas d'autres matériaux semi-conducteurs à l'exception du monocristal semi-conducteur, après la formation du monocristal semi-conducteur.

13. Procédé selon la revendication 10, dans lequel le trou traversant ne contient pas de polycristaux semi-conducteurs, après la formation du monocristal semi-conducteur.

14. Procédé selon la revendication 10, comprenant en outre la liaison de la couche d'isolant électrique à une couche électronique comprenant un système électronique électriquement connecté à l'électrode et configuré pour traiter un signal électrique généré dans la couche semi-conductrice.

15. Détecteur de rayonnement fabriqué en fonction du procédé selon l'une quelconque des revendications 1 à 14.

Fig. 1

Fig. 2A

Fig. 2B

Fig. 2C

110/190

104 / 194

102/192

Fig. 2D

110/190

104 / 194

102/192

Fig. 2E

200

207    204

210    1010

200

207    206    204

210    1020

Fig. 3

200

207    206    204

210    1030

206a    218    210a

200

207    206    204

210    1040

206a    218    219    210a

Fig. 3 (cont.)

200

203

210a

210

1011

Fig. 4

200

203

210a

210

1012

Fig. 4 (cont.)

200
203
207
204
210a
210
1013a

200
203
207
204
210a
210
1013b

Fig. 4 (cont.)

200

207  204
210a
210
1014

Fig. 4 (cont.)

22

200

207     205     204

210a

210

1021

Fig. 5

250

216     213     214

215a

205

210

215b

1022

Fig. 5 (cont.)

Fig. 5 (cont.)

Fig. 6

Fig. 6 (cont.)

Fig. 7

400

403

410a

410

402

410a

2012

Fig. 7 (cont.)

400

403
410b
410
402
410a

407    404

2013a

400

403
410b
410
402
410a

407    404

2013b

Fig. 7 (cont.)

400

410b

407    404

410

402

410a

2014

Fig. 7 (cont.)

400

410b

407    404    405

410

402

410a

2021

Fig. 8

Fig. 8 (cont.)

Fig. 8 (cont.)

Fig. 9A

Fig. 9B

Fig. 10A

Fig. 10B

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006138477 A
- KR 20140083747
- JP 2011257255 B
- WO 2019019040 A